# EUROPEAN PATENT APPLICATION

(11) **EP 4 653 575 A1**
(43) Date of publication of application: **26.11.2025**
(21) Application number: 24191009.0
(22) Date of filing: 25.07.2024
(51) Int. Cl.: C23C 14/00, C23C 14/06, C23C 14/34, C23C 14/35, C23C 28/04, H01J 37/34

(54) **METHOD FOR PREPARING COATING BY CATHODE INTEGRATED HIGH POWER IMPULSE MAGNETRON SPUTTERING (HIPIMS), DEVICE, AND ALUMINUM TITANIUM NITRIDE (ALTIN) COATING**

(30) Priority: 23.05.2024 CN 202410650336
(71) Applicant: Guangdong Huasheng Nano Technology Co., Ltd, Dongguan City Guangdong Province 523000 (CN)
(72) Inventor: CHEN, Yafen, Dongguan City, 523000 (CN); WANG, Xiaoqin, Dongguan City, 523000 (CN); LI, Lisheng, Dongguan City, 523000 (CN); ZHANG, Jiaquan, Dongguan City, 523000 (CN)
(74) Representative: Swea IP Law AB

(57) **Abstract**

Provided are a method for preparing a coating by cathode integrated HiPiMS, a device, and an aluminum titanium nitride (AlTiN) coating. The method includes: subjecting a substrate to the HiPiMS to obtain the coating, where cathode discharge in the cathode integrated HiPiMS is high-current and high-voltage discharge; and in the high-current and high-voltage discharge, a peak current is in a range of 200 A to 2,000 A, a peak voltage is in a range of 200 V to 2,000 V, and a discharge waveform is square.

## Description

### TECHNICAL FIELD

The present disclosure relates to the technical field of coating preparation, and in particular to a method for preparing a coating by cathode integrated high power impulse magnetron sputtering (HiPiMS), a device, and an aluminum titanium nitride (AlTiN) coating.

### BACKGROUND

Physical vapor deposition (PVD) cutting-tool coating is prepared by applying a material onto a surface of a cutting-tool with a PVD method. The PVD cutting-tool coating could improve hardness, wear resistance, chemical stability and other characteristics of the cutting-tool.

At present, PVD technology for coating deposition mainly includes magnetron sputtering (MS) and arc ion plating (AIP). The conventional AIP technology has a high-current discharge characteristic, a high ionization rate and a rapid deposition rate. However, the coating prepared with the AIP is prone to the pollution of "large particles". The large particles refer to neutral particle clusters generated continuously in rolling combustion of arc cathode spots on a surface of a target. These clusters are ejected out together with plasmas, and fall onto a surface of a deposited and grown thin film. Consequently, the surface of the thin film is polluted, which increases roughness of the coating, and reduces adhesion.

High power impulse magnetron sputtering (HiPiMS) technology could improve compactness and film-substrate binding force of a deposited thin film, without the pollution of the large particles. The conventional HiPiMS could realize a high power and a high current instantaneously. However, the technology could not realize continuous discharge at a peak current and a peak power to cause a low ionization rate and a low deposition rate (the deposition rate being 0.1 µm/H to 0.5 µm/H mostly).

### SUMMARY

In view of this, the present disclosure provides a method for preparing a coating by cathode integration, a device and an AlTiN coating. According to the method for preparing the coating by the cathode integrated HiPiMS, a cathode discharge is a high-current and high-voltage discharge, with a discharge waveform being square, and continuous discharge at a peak current could reach a millisecond (ms) level, resulting in high ionization rate and high deposition rate.

To achieve the above objects, the present disclosure provides the following technical solutions.

A method for preparing a coating by cathode integrated HiPiMS, including:
subjecting a substrate to the cathode integrated HiPiMS to obtain the coating, where cathode discharge in the cathode integrated HiPiMS is high-current and high-voltage discharge; and in the high-current and high-voltage discharge, a peak current is in a range of 200 A to 2,000 A, a peak voltage is in a range of 200 V to 2,000 V, and a discharge waveform is square.

In some embodiments, the cathode integrated HiPiMS is operated in a constant current mode or a constant power mode; and
conditions for the cathode integrated HiPiMS include: a cathodic peak current of 200 A to 2,000 A, a cathodic peak voltage of 200 V to 2,000 V, a cathodic average power of 4 KW to 40 KW, a cathodic pulse frequency of 200 Hz to 3,000 Hz, and a cathodic duty cycle of 3% to 40%;
a ratio of a flow of argon (Ar) to a flow of nitrogen (N₂) being 1.4 to 3.5, a chamber pressure of 0.35 Pa to 1 Pa, and a chamber temperature of 500±50°C; and
a substrate bias voltage of -20 V to -200 V, a bias-supply frequency of 20 KHz to 50 KHz, and a bias-supply duty cycle of 30% to 90%.

In some embodiments, there are two targets in the cathode integrated HiPiMS; the targets each are made of an AlTi alloy; and the coating is an AlTiN coating.

In some embodiments, a grain in the AlTiN coating is one or more selected from the group consisting of a coarse columnar grain, a fine columnar grain and a compact grain;
the coarse columnar grain is a columnar grain with a width of 160 nm to 200 nm, a crystalline phase of the coarse columnar grain includes c-AlTiN, and a 200/111 peak intensity of the c-AlTiN in the coarse columnar grain is less than 1.5;
the fine columnar grain is a columnar grain with a width of 80 nm to 140 nm, a crystalline phase of the fine columnar grain includes c-AlTiN, and a 200/111 peak intensity of the c-AlTiN in the fine columnar grain is between 1.5 and 4; and
the compact grain is a columnar grain with a width of 20 nm to 60 nm, a crystalline phase of the compact grain includes c-AlTiN, and a 200/111 peak intensity of the c-AlTiN in the compact grain is greater than 4.

In some embodiments, under a condition that the grain in the AlTiN coating is the coarse columnar grain, conditions for the cathode integrated HiPiMS for preparing the AlTiN coating include: the cathodic peak current of 450±100 A, the cathodic peak voltage of 700±50 V, a flow of N₂ of 130±5 sccm, and a substrate bias voltage of 40±10 V;
under a condition that the grain in the AlTiN coating is the fine columnar grain, conditions for the cathode integrated HiPiMS for preparing the AlTiN coating include: the cathodic peak current of 600±100 A, the cathodic peak voltage of 720±50 V, the flow of N₂ of 140±5 sccm, and the substrate bias voltage of 70±10 V; and
under a condition that the grain in the AlTiN coating is the compact grain, conditions for the cathode integrated HiPiMS for preparing the AlTiN coating include: the cathodic peak current of 750±100 A, the cathodic peak voltage of 750±50 V, the flow of N₂ of 165±5 sccm, and the substrate bias voltage of 70±10 V.

In some embodiments, the AlTiN coating includes a bottom layer and a surface layer; the bottom layer is the fine columnar grain, and the surface layer is the compact grain; the AlTiN coating has a total thickness of 3 µm to 10 µm; and a ratio of a thickness of the surface layer to a thickness of the bottom layer is in a range of 2 to 6.

In some embodiments, before subjecting the substrate to the cathode integrated HiPiMS, the method further includes: subjecting the substrate to chemical solution cleaning, glow cleaning and ion etching, where
gases used for the glow cleaning consists of Ar and hydrogen (H₂), and conditions for the glow cleaning include: a substrate bias voltage of -30 V to -90 V, a flow of the Ar of 100 sccm to 300 sccm, a flow of the H₂ of 100 sccm to 300 sccm, a ratio of the flow of the Ar to the flow of the H₂ being 1.5 to 2.5, and a cleaning time of 40 min to 60 min; and
a gas used for the ion etching is Ar, and conditions for the ion etching include: a flow of the Ar of 200 sccm to 500 sccm, a substrate bias voltage of -100 V to -300 V, and a chamber pressure of 0.8 Pa to 2 Pa.

The present disclosure further provides a cathode integrated magnetron sputtering device used for the method described in the above technical solutions, including a vacuum chamber, a heater, a substrate table, an etching module, a cathode and a cathode power supply, where the cathode is connected to the cathode power supply; and the cathode power supply is configured to control the cathode to perform the high-current and high-voltage discharge.

The present disclosure further provides an AlTiN coating prepared by the method described in the above technical solutions.

The present disclosure further provides use of the AlTiN coating described in the above technical solutions in a cutting-tool.

The present disclosure provides a method for preparing a coating by cathode integrated HiPiMS, including: performing the cathode integrated HiPiMS on a substrate to obtain the coating, where cathode discharge in the cathode integrated HiPiMS is high-current and high-voltage discharge; and in the high-current and high-voltage discharge, a peak current is 200 A to 2,000 A, a peak voltage is 200 V to 2,000 V, and a discharge waveform is square. The present disclosure has the following beneficial effects:

The "cathode integrated HiPiMS" is to realize continuous discharge of a platform on the basis of conventional HiPiMS. In the conventional HiPiMS, a discharge waveform is triangular, and a high power and a high current are realized instantaneously, such that an ionization rate is low and a deposition rate is low. In the "cathode integrated HiPiMS", the discharge waveform is square, and the continuous discharge at the peak current could reach a ms level, such that the ionization rate is high and the deposition rate is high. The deposition rate is 0.5 µm/H to 5 µm/H mostly. The discharge in the present disclosure is a combination of high-current discharge of AIP and high-voltage discharge of conventional MS. The coating prepared by the present disclosure has a smooth surface without droplets, a desirable binding force, a rapid deposition rate and a low internal stress.

Further, for the conventional HiPiMS technology, the discharge waveform is triangular, the continuous discharge could not be realized at the peak current and the peak power, ionized plasmas have a low density and low total energy, and the total energy is adjusted limited through power supply parameters. For the "cathode integrated HiPiMS", the high energy pulse could realize the continuous discharge at the peak current and the peak power. Plasmas have a high density and high energy. By using discharge characteristics, the present disclosure could adjust a grain size, a preferred orientation and a phase structure of the coating through adjusting power supply parameters and process parameters, thereby easily realizing adjustment of hardness and toughness of the coating, and greatly improving performance of the coating. Meanwhile, the present disclosure could further adjust the performance of the coating specifically to expand a process window.

With an AlTiN coating as an example, the conventional HiPiMS technology is hard to accurately adjust a preferred orientation of c-AlTiN, and control a c-AlN phase and a w-AlN phase. Using the "cathode integrated" HiPiMS technology, the preferred orientation of the c-AlTiN is controlled easily. A 200/111 peak intensity of the c-AlTiN could be adjusted to be less than 1.5, such that the coating presents a coarse columnar grain and shows a higher binding force. The 200/111 peak intensity of the c-AlTiN could also be adjusted to be greater than 4, such that the coating tends to form a compact grain, and shows higher compactness, higher hardness and higher wear resistance. The "cathode integrated" HiPiMS technology could prevent generation of the c-AlN phase and the w-AlN phase to achieve better high-temperature stability of the coating, and prevent generation of a soft phase to improve the hardness of the coating.

### BRIEF DESCRIPTION OF THE DRAWINGS

FIG. 1 shows a schematic structural diagram (a) of a cathode integrated magnetron sputtering device and a schematic diagram (b) of a waveform of cathode discharge according to an embodiment of the present disclosure. In FIG. 1, 1 refers to a first cathode, 1-1 refers to a first cathode power supply, 2 refers to a second cathode, 2-2 refers to a second cathode power supply, 3 refers to heaters 1/2, 4 refers to heaters 3/4, 5 refers to heaters 5/6, 6 refers to an etching module, 7 refers to a substrate table, and 8 refers to a substrate carrier;
FIG. 2 shows a scanning electron microscope (SEM) image for a section of the AlTiN coating obtained by Solution 1 in Example 1;
FIG. 3 shows an SEM image for a section of the AlTiN coating obtained by Solution 2 in Example 1;
FIG. 4 shows an SEM image for a section of the AlTiN coating obtained by Solution 3 in Example 1;
FIG. 5 shows an SEM image for a section of the AlTiN coating obtained by Solution 4 in Example 1;
FIG. 6 shows a powder X-ray diffraction (XRD) pattern for the AlTiN coatings respectively obtained by Solution 3, Solution 2 and Solution 5 in Example 1;
FIG. 7 shows a comparison diagram of the cutting-tool wear of the AlTiN coating obtained by Solution 4 and the AlTiN coating obtained by Solution 5 in Example 1 under a 316 turning condition; and
FIG. 8 shows an SEM image of a surface of the AlTiN coating obtained by Solution 4 in Example 1.

### DETAILED DESCRIPTION OF THE EMBODIMENTS

Definition: In the present disclosure, "cathode integrated HiPiMS" refers to a HiPiMS process that exhibits high-current (adjustable in a range of 200 A to 2,000 A) and high-voltage (adjustable in a range of 200 V to 2,000 V) discharge at the same time, and could maintain certain discharge time (µs to ms).

The present disclosure provides a method for preparing a coating by cathode integrated HiPiMS, including:
subjecting a substrate to the cathode integrated HiPiMS to obtain the coating,
wherein cathode discharge in the cathode integrated HiPiMS is high-current and high-voltage discharge; and in the high-current and high-voltage discharge, a peak current is in a range of 200 A to 2,000 A, a peak voltage is in a range of 200 V to 2,000 V, and a discharge waveform is square.

In the present disclosure, the cathode integrated HiPiMS has a deposition rate of 0.5 µm/H to 5 µm/H. Continuous discharge time at a peak current could reach a ms level, and could be 10 ms at maximum. In a specific embodiment of the present disclosure, the continuous discharge time at the peak current is ≤10 ms, preferably 0.1 ms to 10 ms, and more preferably 0.2 ms to 1 ms.

In some embodiments of the present disclosure, the substrate is made of a hard alloy, and is specifically a hard alloy blade and a square test block. In some embodiments of the present disclosure, a WC type is used by the hard alloy.

In some embodiments of the present disclosure, before subjecting the substrate to the cathode integrated HiPiMS, the method further includes: subjecting the substrate to chemical solution cleaning, glow cleaning and ion etching. In some embodiments of the present disclosure, a cleaning agent used in the chemical solution cleaning is a neutral cleaning agent. In the present disclosure, there are no special requirements on a type of the neutral cleaning agent, and any neutral cleaning agent well known to those skilled in the art may be adopted. Specifically, the neutral cleaning agent is a DH-316 cleaning agent and a 1102H cleaning agent for example. Through the chemical solution cleaning, the present disclosure removes adhesives, oil stains and paraffins on a surface of the substrate. In some embodiments of the present disclosure, gases used for the glow cleaning consists of Ar and H₂, and conditions for the glow cleaning include: a substrate bias voltage of -30 V to -90 V, preferably 50 V to -70 V, a flow of the Ar of 100 sccm to 300 sccm, preferably 150 sccm to 250 sccm, a flow of the H₂ of 100 sccm to 300 sccm, preferably 130 sccm to 200 sccm, a ratio of the flow of the Ar to the flow of the H₂ being 1.4 to 2.5, a cleaning time of 40 min to 60 min, and a chamber pressure of 1 Pa to 2 Pa, preferably 1.2 Pa. Through the glow cleaning, the present disclosure further removes the oil stains on the surface of the substrate. In some embodiments of the present disclosure, a gas used for the ion cleaning is Ar, and conditions for the ion etching include: a flow of the Ar of 200 sccm to 500 sccm, preferably 300 sccm to 400 sccm, a substrate bias voltage of -100 V to -300 V, preferably -150 V to -250 V, and a chamber pressure of 0.8 Pa to 2 Pa, preferably 1 Pa to 1.5 Pa. Through the ion etching, the present disclosure removes stubborn impurities on the surface of the substrate continuously, improves surface roughness of the substrate, and improves a binding force between the coating and the substrate.

In a specific embodiment of the present disclosure, upon completion of the chemical solution cleaning, the substrate is placed into a vacuum coating machine, and vacuumized to ≤5×10⁻³ Pa. A heating module is started to heat a chamber temperature to a working temperature. In some embodiments of the present disclosure, the working temperature is 500±50°C. Then the glow cleaning is performed under the above conditions. Upon completion of the glow cleaning, a bias voltage is increased to a bias voltage required by the ion etching. H₂ is closed, and only Ar is charged. The ion etching is performed under the above conditions.

Upon completion of the ion etching, the substrate is subjected to the cathode integrated HiPiMS, thereby obtaining the coating on the surface of the substrate. In some embodiments of the present disclosure, the cathode integrated HiPiMS is operated in a constant current mode or a constant power mode; and conditions for the cathode integrated HiPiMS include: a cathodic peak current of 200 A to 2,000 A, preferably 300 A to 800 A, a peak voltage of 200 V to 2,000 V, preferably 300 V to 800 V, a cathodic average power of 8 KW to 30 KW, preferably 10 KW to 25 KW, a cathodic pulse frequency of 200 Hz to 3,000 Hz, preferably 250 Hz to 2,000 Hz, and a cathodic duty cycle of 3% to 40%, preferably 5% to 20%; a ratio of a flow of Ar to a flow of N₂ being 1.5 to 3.5, preferably 2 to 3, a chamber pressure of 0.35 Pa to 1 Pa, preferably 0.4 Pa to 0.8 Pa, and a chamber temperature of 500±50°C; and a substrate bias voltage of -20 V to -200 V, preferably -30 V to -90 V, a bias-supply frequency of 20 KHz to 50 KHz, and a bias-supply duty cycle of 30% to 90%, preferably 40% to 80%.

In some embodiments of the present disclosure, there are two targets in the cathode integrated HiPiMS. In some embodiments of the present disclosure, the targets are symmetrically provided at two sides of a substrate carrier.

In a specific embodiment of the present disclosure, the targets each are made of an AlTi alloy. In a specific embodiment of the present disclosure, the AlTi alloy consists of 70 at.% of Al and 30 at.% of Ti. In a specific embodiment of the present disclosure, when the AlTi alloy is used as the target, the coating is an AlTiN coating.

In the present disclosure, for the cathode integrated HiPiMS, the continuous discharge could be realized at the peak current and a peak power. Plasmas have a high density and high energy. The present disclosure could adjust a grain size, a preferred orientation and a phase structure of the coating through adjusting power supply parameters and process parameters, thereby greatly improving performance of the coating. The AlTiN coating is used as an example below for detailed description.

In some embodiments of the present disclosure, a grain in the AlTiN coating is one or more selected from the group consisting of a coarse columnar grain, a fine columnar grain and a compact grain; the coarse columnar grain is a columnar grain with a width of 160 nm to 200 nm, a crystalline phase of the coarse columnar grain includes c-AlTiN, and a 200/111 peak intensity of the c-AlTiN in the coarse columnar grain is less than 1.5, preferably greater than or equal to 1 and less than 1.5; the fine columnar grain is a columnar grain with a width of 80 nm to 140 nm, a crystalline phase of the fine columnar grain includes c-AlTiN, and a 200/111 peak intensity of the c-AlTiN in the fine columnar grain is between 1.5 and 4; and the compact grain is a columnar grain with a width of 20 nm to 60 nm, a crystalline phase of the compact grain includes c-AlTiN, and a 200/111 peak intensity of the c-AlTiN in the compact grain is greater than 4, preferably 4 to 6.

In some embodiments of the present disclosure, under a condition that the grain in the AlTiN coating is the coarse columnar grain, conditions for the cathode integrated HiPiMS for preparing the AlTiN coating include: the cathodic peak current of 450±100 A, preferably 450±30 A, the cathodic peak voltage of 700±50 V, and the flow of N₂ of 130±5sccm, and a substrate bias voltage of 40±10 V.

In some embodiments of the present disclosure, under a condition that the grain in the AlTiN coating is the fine columnar grain, conditions for the cathode integrated HiPiMS for preparing the AlTiN coating include: the cathodic peak current of 600±100 A, preferably 600±30 A, the cathodic peak voltage of 720±50 V, the flow of N₂ of 140±5 sccm, preferably 142 sccm, and the substrate bias voltage of 70±10 V.

In some embodiments of the present disclosure, under a condition that the grain in the AlTiN coating is the compact grain, conditions for the cathode integrated HiPiMS for preparing the AlTiN coating include: the cathodic peak current of 750±100 A, preferably 750±30 A, the cathodic peak voltage of 750±50 V, the flow of N₂ of 165±5 sccm, and the substrate bias voltage of 70±10 V.

In some embodiments of the present disclosure, the AlTiN coating includes a bottom layer and a surface layer; the bottom layer is the fine columnar grain, and the surface layer is the compact grain. In some embodiments, the AlTiN coating has a total thickness of 3 µm to 10 µm; and a ratio of a thickness of the surface layer to a thickness of the bottom layer is in a range of 2 to 6, and preferably 3 to 5. In the present disclosure, the AlTiN coating being the fine columnar grain has a higher binding force with the substrate. The AlTiN coating being the compact grain has higher hardness. The present disclosure combines the bottom layer being the fine columnar grain with the surface layer being the compact grain. The bottom layer could ensure the high binding force, and the surface layer could increase the hardness of the coating, and improve the crack extension resistance of the coating. The combination of the bottom layer and the surface layer is applied to a scenario in which the high binding force and the high hardness are required.

In some embodiments of the present disclosure, upon completion of the cathode integrated HiPiMS, degassing is performed. Upon preparation of the coating, there is a process gas in a chamber. In some embodiments of the present disclosure, a mechanical pump and a molecular pump are maintained for a certain time to pump the process gas, such that the chamber is restored to an original vacuum degree for leakage detection of a device.

In some embodiments of the present disclosure, upon completion of the degassing, cooling is performed. After the vacuum coating machine is cooled to a preset temperature (≤200°C), a coated substrate (namely a coated product) is taken out.

The present disclosure further provides a cathode integrated magnetron sputtering device used for the method described in the above technical solutions, including a vacuum chamber, a heater, a substrate table, an etching module, a cathode and a cathode power supply, where the cathode is connected to the cathode power supply; and the cathode power supply is configured to control the cathode to perform the high-current and high-voltage discharge.

In some embodiments of the present disclosure, a substrate table is provided in a center of a vacuum chamber. A plurality of substrate carriers are arranged on the substrate table. The substrate carriers are configured to place the substrate. A plurality of substrates may be provided on each of the substrate carriers, so as to sputter a plurality of the substrates at the same time.

In some embodiments of the present disclosure, there are six heaters. Two the heaters are formed into one pair (called a heating module), and there are three pairs of the heaters. In some embodiments of the present disclosure, the three pairs of the heaters are provided uniformly around the substrate carrier. In a specific embodiment of the present disclosure, the three pairs of the heaters are respectively labeled as heaters 1/2, heaters 3/4 and heaters 5/6.

In some embodiments of the present disclosure, there are two cathodes. The two cathodes are symmetrically provided at two sides of the substrate carrier. In some embodiments of the present disclosure, there are two cathode power supplies. The cathodes each are connected to one of the cathode power supplies. The cathode includes a back plate and a target on the back plate. In a specific embodiment of the present disclosure, the two cathodes are respectively labeled as a first cathode and a second cathode. The cathode power supply connected to the first cathode is labeled as a first cathode power supply. The cathode power supply connected to the second cathode is labeled as a second cathode power supply. In the present disclosure, the cathode power supply is configured to control the cathode to perform the high-current and high-voltage discharge, and control the square waveform. In the present disclosure, there are no special requirements for the cathode power supply, and commercially-available power supplies may be adopted as long as the cathode could realize the high-current and high-voltage discharge.

In the present disclosure, there are no special requirements on the structure and position of the etching module, and any etching module having the structure and position well known to those skilled in the art may be adopted. Specifically, the etching module may be provided at one side of the substrate carrier.

The present disclosure further provides an AlTiN coating prepared by the method described in the above technical solutions. In a specific embodiment of the present disclosure, the AlTiN coating is a coating with a bottom layer being a fine columnar grain and a surface layer being a compact grain. The specific thickness and the preparation method of the AlTiN coating are not repeated herein.

The present disclosure further provides use of the AlTiN coating described in the above technical solutions in a cutting-tool. In a specific embodiment of the present disclosure, when the AlTiN coating is applied to the cutting-tool, the cutting-tool is directly used as a substrate for coating. In the present disclosure, there are no special requirements on a type of the cutting-tool, and any cutting-tool well known to those skilled in the art may be adopted. By preparing the AlTiN coating of the present disclosure on a surface of the cutting-tool, the hardness and wear resistance of the cutting-tool could be effectively improved, and the binding force between the coating and the cutting-tool substrate is strong.

The technical solutions of the present disclosure will be clearly and completely described below in conjunction with the examples of the present disclosure. Apparently, the described embodiments are merely a part rather than all of the examples of the present disclosure. All other embodiments obtained by those skilled in the art based on the embodiments of the present disclosure without creative efforts shall fall within the scope of the present disclosure.

### Example 1

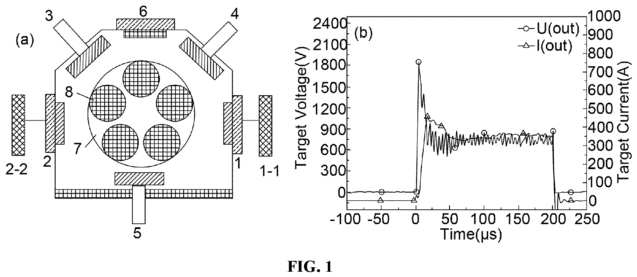

1. Pretreatment (chemical solution cleaning): A cleaning agent was used to clean oil stains and oxides on a surface of a substrate. The substrate was made of a WC hard alloy.
2. Vacuumization: The substrate was placed into a vacuum coating machine. The vacuum coating machine was vacuumized to have a vacuum degree of 5×10⁻³ Pa.
3. Heating: A heating module was started to heat a chamber temperature to a working temperature of 500°C.
4. Glow cleaning and ion etching: Ar and H₂ were charged at a bias voltage of -60 V. The Ar had a flow of 200 sccm, and the H₂ had a flow of 100 sccm. The glow cleaning lasted for 60 min, and was mainly intended to remove oil stains on a surface of a cutting-tool. A ratio of the flow of the Ar to the flow of the H₂ was 2, and a chamber pressure was 1.2 Pa. Upon completion of the glow cleaning, the bias voltage was increased. H₂ was closed, and only 300 sccm of Ar was charged. Under the bias voltage of -240 V, and the chamber pressure of 1.05 Pa, the ion etching was performed, thereby continuously removing stubborn impurities on the surface of the coated cutting-tool substrate, improving surface roughness of the substrate, and improving a binding force between the coating and the substrate.
5. Coating deposition
   (1) A specific coating device and a waveform of cathode discharge of a target are shown in FIG. 1. In preparation, Cathodes 1 and 2 were opened at the same time. Two cathode targets worked at the same time. The cathode targets were AlTi7030 at.% targets.
   (2) A peak current of the coating was set. A constant current mode was used. The peak current and the peak voltage are shown in Table 1.
   (3) The cathode had a pulse frequency of 600 Hz, and a duty ratio of 12%. The peak current was maintained for 200 µs in the following solutions.
   (4) A ratio of Ar to N₂ was 1.4. A flow of the N₂ is shown in Table 1. A chamber pressure was 0.7 Pa.
   (5) A substrate bias voltage is shown in Table 1. A power supply of the substrate had a frequency of 30 KHz, and a duty ratio of 80%.
6. Degassing: Upon preparation of the coating, there was a process gas in a chamber. A mechanical pump and a molecular pump were maintained for a certain time to pump the process gas, such that the chamber was restored to an original vacuum degree for leakage detection of the device.
7. Cooling: Cooling was performed to obtain a coated product. Upon completion of coating, the vacuum coating machine was cooled. After cooling to a preset temperature, a coated substrate (finished cutting-tool product) was taken out from the vacuum coating machine. All film layers were tested for hardness, with results shown in Table 1.

**Table 1: Data sheet of test parameters**

| | Peak current (A) | Peak voltage (V) | Flow of N₂ (sccm) | Bias voltage (V) | Hardness (GPa) | Stress (GPa) | Deposition rate (µm/h) | Note |
|---|---|---|---|---|---|---|---|---|
| Solution 1 | 450±30 | 700V±50 | 130 | 40 | 32.6 | -3.4 | 0.9 | Coarse columnar grain |
| Solution 2 | 600±30 | 720V±50 | 142 | 70 | 35.3 | -4.5 | 1.1 | Fine columnar grain |
| Solution 3 | 750±30 | 750V±50 | 165 | 70 | 38.4 | -5.1 | 1.4 | Compact grain |
| Solution 4 | A bottom layer is prepared with Solution 2. A surface layer is prepared with Solution 3. The coating has a total thickness of 3 µm to 10 µm. A ratio of a thickness of the surface layer to a thickness of the bottom layer is 2 to 6. | | | | 37.2 | -4.8 | 1.25 | Fine columnar grain on the bottom layer + compact grain on the surface layer |
| Solution 5 | 300±30 | 670V±50 | 115±5 | 40 | 28.1 | -2.9 | 0.75 | A c-AlN phase and a w-AlN phase are generated |

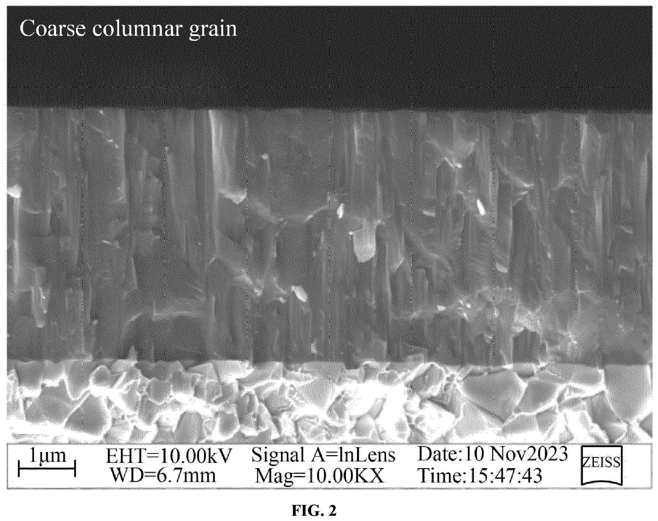

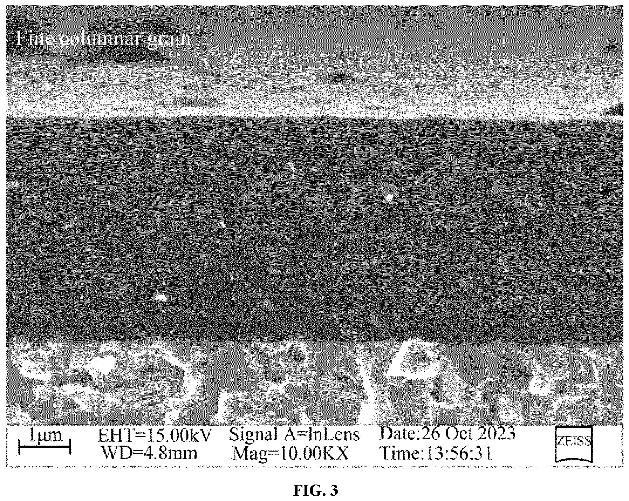

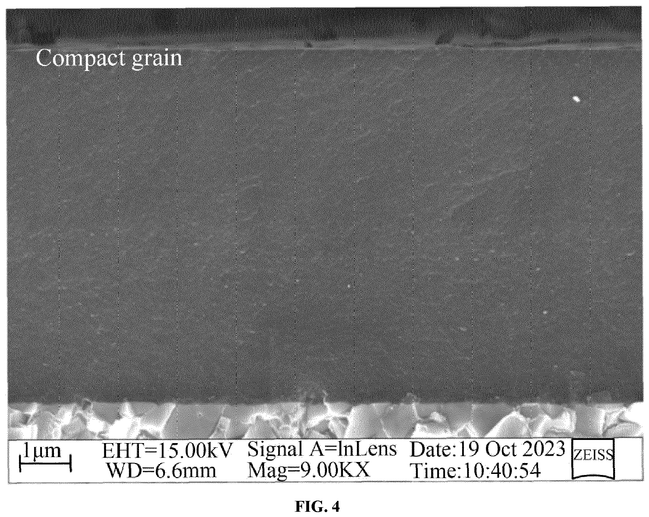

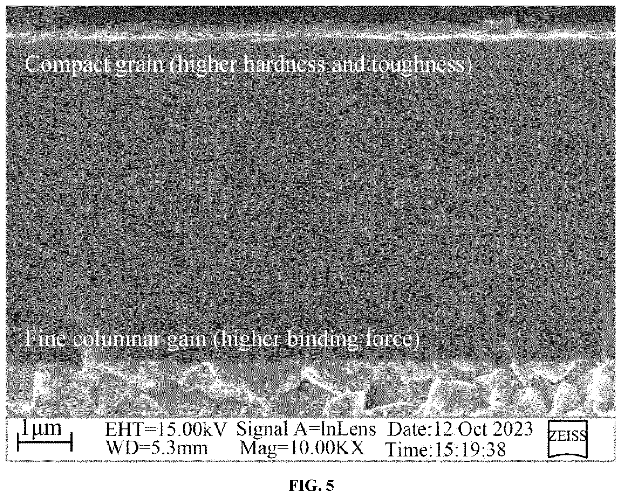

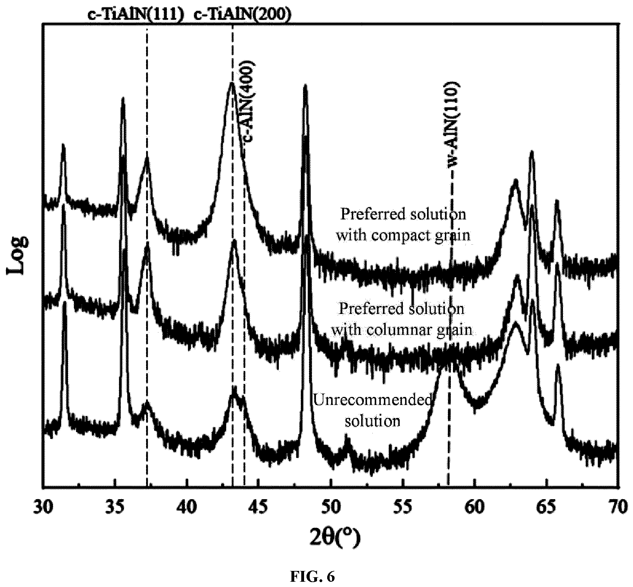

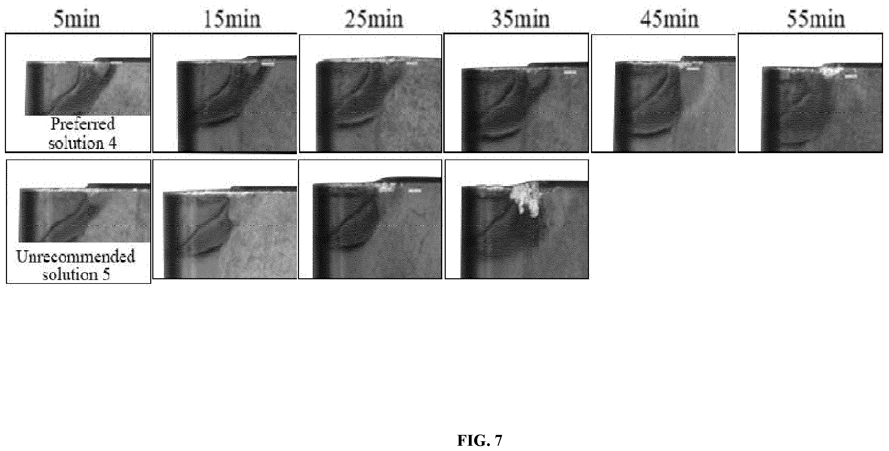

Detection on the coating:
1. SEM section analysis: With an SEM, a section of the coating was amplified to 10 K to 60 K, and a morphology of a grain size in growth was observed. The observation results for the coatings obtained by the Solution 1 to Solution 3 are shown in FIG. 2 to FIG. 4. As can be seen from FIG. 2 to FIG. 4, by setting process parameters, the columnar grain with the adjustable size and the compact grain with the adjustable size are prepared. For a scenario needing a high binding force and high hardness, a combination of the bottom layer being the fine columnar grain and the surface layer being the compact grain (Solution 4) is preferably used. The bottom layer could ensure the high binding force, and the surface layer could increase the hardness of the coating and improve the crack extension resistance of the coating. The observation result for the coating obtained by Solution 4 is shown in FIG. 5.
2. Crystal orientation analysis through XRD: An XRD test is performed on the coatings respectively obtained by the Solution 3 (the compact grain is preferable), Solution 2 (the columnar grain is preferable) and Solution 5 (unrecommended solution), with a result shown in FIG. 6. A peak intensity at (111) and a peak intensity at (200) are compared. Preferably, the bottom layer has a (200)/(111) peak intensity ratio of 1.5 to 4, such that the coating shows the fine columnar grain and the high binding force. Preferably, the surface layer has a (200)/(111) peak intensity ratio of greater than 4, most preferably 4 to 6, such that the coating shows the compact columnar grain, and has the high compactness and the high hardness. Meanwhile, by controlling generation of c-AlN and w-AlN, the coating has better high-temperature stability and higher hardness.
3. Hardness analysis through nanoindentation: A nanoindentation tester from the Anton Paar is used for testing. The tested depth of an indenter is < 1/10 of the thickness of the coating. 15 points are selected for each sample, and averaging is performed to obtain the hardness of the coating. Specific test results are shown in Table 1. As can be seen from the test results, in the Solution 5, in the case of the c-AlN phase and the w-AlN phase in the coating, the coating has lowest hardness, followed by the coating being the coarse columnar grain.
4. Cutting test: FIG. 7 shows a cutting-tool wear comparison diagram of the coating obtained by the Solution 4 and the coating obtained by the Solution 5 under a 316 turning condition. The cutting-tool substrate is a hard alloy turning blade, and specifically has the following machining parameters: Vc=260/min, fn=0.4 mm/min, ap=1.0 mm, and water cooling is performed. As can be seen from the wear comparison diagram, the coating in preferred Solution 4 has a longer service life than the coating in unrecommended Solution 5 by 60% or more. This fully demonstrates that the coating in preferred Solution 4 has better wear resistance.
5. SEM test on the surface of the coating

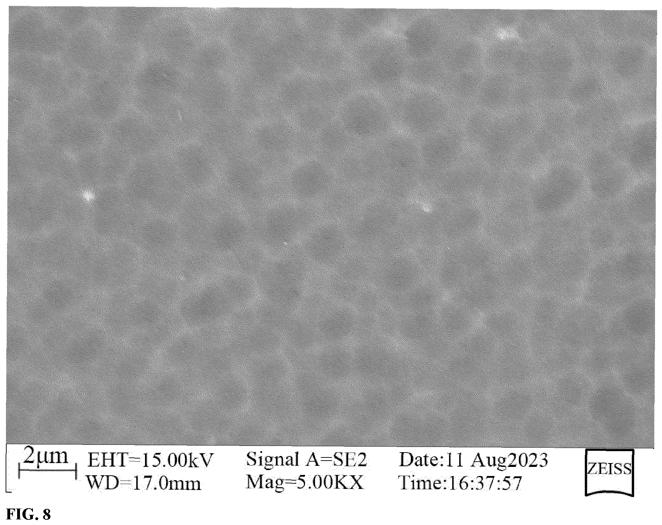

FIG. 8 shows an SEM image of the surface of the coating obtained by the Solution 4. As can be seen from FIG. 8, the surface of the coating is smooth and droplet-free.

According to the results in the above example, the method for preparing a coating by cathode integrated HiPiMS provided by the present disclosure could realize a high ionization rate and a high deposition rate. The deposition rate is 0.5 µm/H to 5 µm/H mostly, which is obviously higher than the deposition rate of conventional HiPiMS. By using discharge characteristics, the present disclosure could adjust the columnar grain and the compact grain of the coating, adjust a (200)/(111) peak intensity ratio of the c-AlTiN, adjust a phase structure of the c-AlN and the w-AlN, and adjust the hardness, toughness and binding force of the coating. The present disclosure could adjust performance of the coating specifically to expand a process window, thereby greatly improving the performance of the coating. In addition, the present disclosure could prepare the coating combined with advantages of a coating prepared by AIP and advantages of a coating prepared by MS. That is, the coating prepared by the present disclosure features a smooth surface without droplets, a high deposition rate, a high ionization rate, a low stress, etc.

The above descriptions are merely preferred embodiments of the present disclosure. It should be noted that a person of ordinary skill in the art may further make several improvements and modifications without departing from the principle of the present disclosure, but such improvements and modifications should be deemed as falling within the scope of the present disclosure.

## Claims

1. A method for preparing a coating by cathode integrated high power impulse magnetron sputtering (HiPiMS), comprising:
subjecting a substrate to the HiPiMS to obtain the coating,
wherein cathode discharge in the cathode integrated HiPiMS is high-current and high-voltage discharge; and in the high-current and high-voltage discharge, a peak current is in a range of 200 A to 2,000 A, a peak voltage is in a range of 200 V to 2,000 V, and a discharge waveform is square.

2. The method of claim 1, wherein the cathode integrated HiPiMS is operated in a constant current mode or a constant power mode; and
conditions for the cathode integrated HiPiMS comprise:
a cathodic peak current of 200 A to 2,000 A, a cathodic peak voltage of 200 V to 2,000 V, a cathodic average power of 4 KW to 40 KW, a cathodic pulse frequency of 200 Hz to 3,000 Hz, and a cathodic duty cycle of 3% to 40%;
a ratio of a flow of argon (Ar) to a flow of nitrogen (N₂) being 1.4 to 3.5, a chamber pressure of 0.35 Pa to 1 Pa, and a chamber temperature of 500±50°C; and
a substrate bias voltage of -20 V to -200 V, a bias-supply frequency of 20 KHz to 50 KHz, and a bias-supply duty cycle of 30% to 90%.

3. The method of claim 2, wherein there are two targets in the cathode integrated HiPiMS; the targets each are made of an AlTi alloy; and the coating is an aluminum titanium nitride (AlTiN) coating.

4. The method of claim 3, wherein a grain in the AlTiN coating is one or more selected from the group consisting of a coarse columnar grain, a fine columnar grain and a compact grain;
the coarse columnar grain is a columnar grain with a width of 160 nm to 200 nm, a crystalline phase of the coarse columnar grain comprises c-AlTiN, and a 200/111 peak intensity of the c-AlTiN in the coarse columnar grain is less than 1.5;
the fine columnar grain is a columnar grain with a width of 80 nm to 140 nm, a crystalline phase of the fine columnar grain comprises c-AlTiN, and a 200/111 peak intensity of the c-AlTiN in the fine columnar grain is between 1.5 and 4; and
the compact grain is a columnar grain with a width of 20 nm to 60 nm, a crystalline phase of the compact grain comprises c-AlTiN, and a 200/111 peak intensity of the c-AlTiN in the compact grain is greater than 4.

5. The method of claim 4, wherein under a condition that the grain in the AlTiN coating is the coarse columnar grain, conditions for the cathode integrated HiPiMS for preparing the AlTiN coating comprise: the cathodic peak current of 450±100 A, the cathodic peak voltage of 700±50 V, the flow of N₂ of 130±5 sccm, and the substrate bias voltage of 40±10 V;
under a condition that the grain in the AlTiN coating is the fine columnar grain, conditions for the cathode integrated HiPiMS for preparing the AlTiN coating comprise: the cathodic peak current of 600±100 A, the cathodic peak voltage of 720±50 V, the flow of N₂ of 140±5 sccm, and the substrate bias voltage of 70±10 V; and
under a condition that the grain in the AlTiN coating is the compact grain, conditions for the cathode integrated HiPiMS for preparing the AlTiN coating comprise: the cathodic peak current of 750±100 A, the cathodic peak voltage of 750±50 V, the flow of N₂ of 165±5 sccm, and the substrate bias voltage of 70±10 V.

6. The method of claim 5, wherein the AlTiN coating comprises a bottom layer and a surface layer; the bottom layer is the fine columnar grain, and the surface layer is the compact grain; the AlTiN coating has a total thickness of 3 µm to 10 µm; and a ratio of a thickness of the surface layer to a thickness of the bottom layer is in a range of 2 to 6.

7. The method of claim 1, before subjecting the substrate to the cathode integrated HiPiMS, further comprising: subjecting the substrate to chemical solution cleaning, glow cleaning and ion etching, wherein
gases used for the glow cleaning consists of Ar and hydrogen (H₂), and conditions for the glow cleaning comprise: a substrate bias voltage of -30 V to -90 V, a flow of the Ar of 100 sccm to 300 sccm, a flow of the H₂ of 100 sccm to 300 sccm, a ratio of the flow of the Ar to the flow of the H₂ being 1.5 to 2.5, a cleaning time of 40 min to 60 min, and a chamber pressure of 1 Pa to 2 Pa; and
a gas used for the ion etching is Ar, and conditions for the ion etching comprise: a flow of the Ar of 200 sccm to 500 sccm, a substrate bias voltage of -100 V to -300 V, and a chamber pressure of 0.8 Pa to 2 Pa.

8. A cathode integrated magnetron sputtering device used for the method of any one of claims 1 to 7, comprising a vacuum chamber, a heater, a substrate table, an etching module, a cathode and a cathode power supply, wherein
the cathode is connected to the cathode power supply; and
the cathode power supply is configured to control the cathode to perform the high-current and high-voltage discharge.

9. An AlTiN coating prepared by the method of any one of claims 1 to 7.

10. Use of the AlTiN coating of claim 9 in a cutting-tool.
